# DEMANDE DE BREVET EUROPEEN

(11) **EP 2 767 869 A1**
(43) Date de publication de la demande: **20.08.2014**
(21) Numéro de dépôt: 13155068.3
(22) Date de dépôt: 13.02.2013
(51) Int. Cl.: G03F 7/00, B81C 1/00

(54) **Procédé de fabrication d'une pièce de micromécanique monobloc comportant au moins deux niveaux distincts**

(71) Demandeur: Nivarox-FAR S.A., 2400 Le Locle (CH)
(72) Inventeur: Fussinger, Alexandre, 2075 Wavre (CH); Stranczl, Marc, 1260 Nyon (CH)
(74) Mandataire: Couillard, Yann Luc Raymond

(57) **Abrégé**

L'invention se rapporte à un procédé (1) de fabrication d'une pièce de micromécanique (31, 41, 61, 91) monobloc comportant au moins deux niveaux distincts. Selon l'invention, le procédé (1) comporte un processus LIGA à un seul niveau combiné avec un usinage du dépôt LIGA directement sur le substrat (2).

L'invention concerne le domaine des pièces de micromécanique horlogères.

## Description

### Domaine de l'invention

L'invention se rapporte à un procédé de fabrication d'une pièce de micromécanique monobloc comportant au moins deux niveaux distincts.

### Arrière-plan de l'invention

Il est connu de former des pièces métalliques à plusieurs niveaux distincts à l'aide de procédé du type LIGA successifs, c'est-à-dire à partir de couches empilées comportant un moule structuré en résine et un métal dans les creux du moule déposé par galvanoplastie.

Toutefois, ces procédés successifs pour former plusieurs niveaux sont difficiles à mettre en oeuvre car il est nécessaire de correctement référencer les niveaux entre eux. De plus, il est apparu que cette difficulté engendrait des couts très supérieurs par rapport à deux dépôts galvaniques à un seul niveau.

### Résumé de l'invention

Le but de la présente invention est de pallier tout ou partie les inconvénients cités précédemment en proposant un procédé alternatif de fabrication d'une pièce de micromécanique monobloc comportant au moins deux niveaux distincts, moins cher à mettre en oeuvre.

A cet effet, l'invention se rapporte à un procédé de fabrication d'une pièce de micromécanique monobloc comportant au moins deux niveaux distincts **caractérisé en ce qu'il** comporte les étapes suivantes :
a) former un substrat en silicium dont la surface supérieure est électriquement conductrice ;
b) structurer un moule à partir d'une résine photosensible afin de fabriquer des cavités dont le fond est formé par ladite face supérieure électriquement conductrice ;
c) remplir les cavités du moule par galvanoplastie pour former une pièce métallique ;
d) usiner sélectivement une partie de la pièce métallique afin de former une pièce de micromécanique monobloc à au moins deux niveaux distincts ;
e) libérer la pièce de micromécanique du substrat et de la résine photosensible.

On comprend avantageusement selon l'invention que chaque pièce de micromécanique monobloc comportant au moins deux niveaux distincts est formée à partir d'une pièce métallique selon un motif unique formé par un procédé LIGA qui est ensuite usinée directement sur le substrat afin de bénéficier du positionnement précis de chaque pièce métallique sur le substrat.

Par conséquent, les cotes externes et, éventuellement, internes restent à la grande précision induit par le procédé LIGA et le reste de la pièce de micromécanique monobloc bénéficie de la précision de l'usinage, moins avantageuse par rapport au procédé LIGA, afin de préserver les couts de fabrication. On obtient donc une pièce de micromécanique monobloc comportant au moins deux niveaux distincts qui est beaucoup moins difficile à fabriquer en gardant les parties externes et, éventuellement, internes d'une très grande précision.

Conformément à d'autres caractéristiques avantageuses de l'invention :
- la surface supérieure est rendue électriquement conductrice par le dopage du substrat en silicium et/ou par le dépôt d'une couche électriquement conductrice sur le substrat en silicium ;
- le substrat en silicium comporte une épaisseur comprise entre 0,3 et 1 mm ;
- l'étape b) comporte les phases f) : déposer une couche de résine photosensible sur la surface supérieure électriquement conductrice du substrat, g) : illuminer sélectivement une partie de la résine photosensible et h) : développer la résine photosensible afin de structurer le moule ;
- la pièce métallique est formée à base de nickel-phosphore comme du NiP ou du NiP12 ;
- le procédé comporte en outre entre l'étape c) et l'étape d), l'étape i) : mettre à niveau, par rodage, le moule et la pièce métallique ;
- lors de l'étape e), le procédé comporte les phases j) : retirer la résine photosensible et k) : retirer le substrat ;
- entre la phase j) et la phase k), le procédé comporte en outre la phase l) : déposer un revêtement sur l'ensemble pièce de micromécanique - substrat ;
- la phase l) est réalisée par dépôt physique ou chimique en phase vapeur ou par galvanoplastie ;
- plusieurs pièces de micromécanique sont formées sur le même substrat.

De plus, l'invention se rapporte à une pièce d'horlogerie **caractérisée en ce qu'**elle comporte une pièce de micromécanique monobloc à au moins deux niveaux distincts obtenue selon l'une des variantes précédentes.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations d'étapes successives d'un procédé selon un premier mode de réalisation de l'invention ;
- les figures 6 et 7 sont des représentations d'étapes finales d'un procédé selon un deuxième mode de réalisation de l'invention ;
- les figures 8 à 10 sont des représentations d'une pièce métallique électroformée puis usinée à l'aide d'un procédé selon une première variante de l'invention ;
- les figures 11 à 13 sont des représentations d'une pièce métallique électroformée puis usinée à l'aide d'un procédé selon une deuxième variante de l'invention puis assemblée ;
- les figures 14 à 16 sont des représentations de pièce métallique électroformée puis usinée à l'aide d'un procédé selon une troisième variante de l'invention puis assemblée ;
- la figure 17 est un schéma fonctionnel d'un procédé selon l'invention.

### Description détaillée des modes de réalisation préférés

Le but de la présente invention est de proposer un procédé de fabrication d'une pièce de micromécanique monobloc comportant au moins deux niveaux distincts qui soit moins cher à mettre en oeuvre. La présente invention a également pour but de fabriquer tout ou partie d'une pièce de micromécanique à partir de ce procédé. La pièce de micromécanique est destinée à être montée préférentiellement dans une pièce d'horlogerie. Bien entendu, il est également envisageable d'appliquer la présente invention dans d'autres domaines comme, notamment, l'aéronautique ou l'automobile.

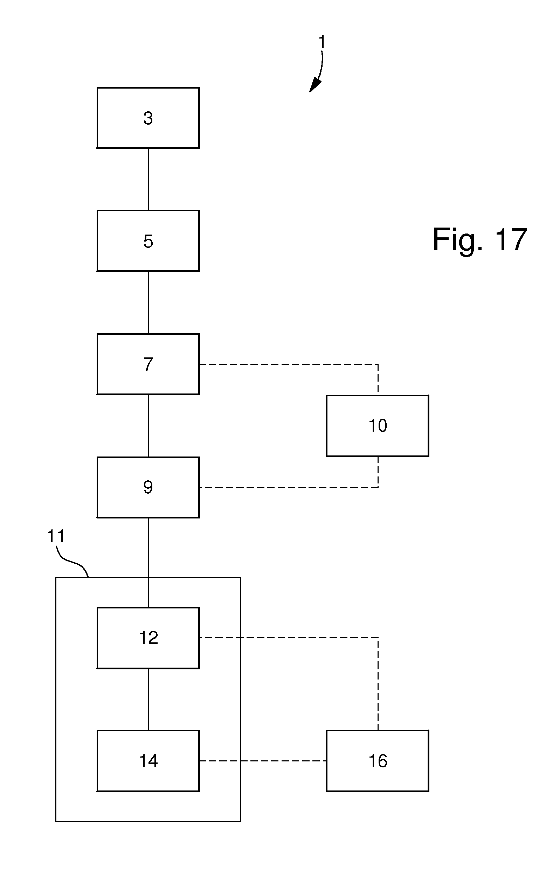

Comme illustré à la figure 17, l'invention se rapporte à un procédé 1 de fabrication d'une pièce de micromécanique 31, 41, 61, 91 monobloc comportant au moins deux niveaux distincts.

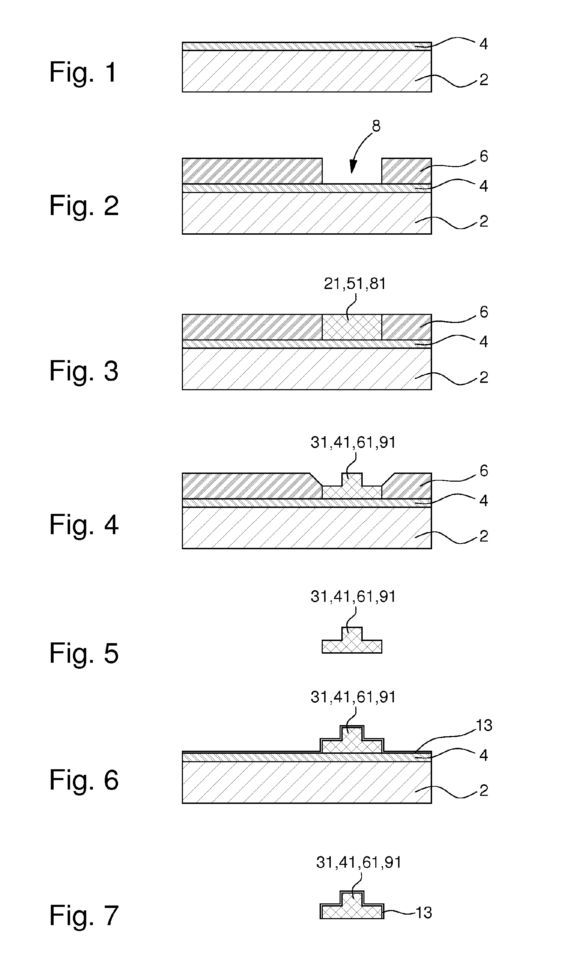

Selon le procédé 1, une première étape 3, comme illustrée à la figure 1, est destinée à former un substrat 2 en silicium dont la surface supérieure 4 est électriquement conductrice. Préférentiellement, la surface supérieure 4 est électriquement conductrice par le dopage du substrat 2 en silicium et/ou par le dépôt d'une couche électriquement conductrice sur le substrat 2 en silicium.

Dans tous les cas, il est très important que l'adhérence du futur dépôt galvanique contre le substrat 2 soit la plus forte possible. En effet, il est primordial pour l'étape 9 que la pièce métallique 21, 51, 81 soit très fortement fixée contre la surface supérieure 4 et, incidemment, contre le substrat 2.

Préférentiellement selon l'invention, le substrat 2 en silicium comporte une épaisseur comprise entre 0,3 et 1 mm. De plus, dans le cas où une couche électriquement conductrice serait utilisée, cette dernière serait de manière préférée à base d'or, c'est-à-dire en or pur ou un de ses alliages. Enfin, elle pourrait être, par exemple, déposée par dépôt physique ou chimique en phase vapeur ou tout autre méthode de dépôt.

Le procédé 1 se poursuit, comme illustré à la figure 2, avec une deuxième étape 5 destinée à structurer un moule à partir d'une résine photosensible 6 afin de fabriquer des cavités 8 dont le fond est formé par la face supérieure 4 électriquement conductrice du substrat 2.

Bien évidemment, la figure 2 n'est qu'une représentation simplifiée et des formes très complexes peuvent être structurées. Ainsi, plusieurs cavités 8, n'étant pas nécessairement de formes identiques, peuvent être structurées dans la résine 6 lors de l'étape 5 afin que plusieurs pièces de micromécanique 31, 41, 61, 91 puissent être formées sur le même substrat 2.

L'étape 5 comporte préférentiellement les trois phases. L'étape 5 comporte une première phase destinée à déposer une couche de résine 6 photosensible sur la surface supérieure 4 électriquement conductrice du substrat 2. Une telle phase peut être obtenue par enduction centrifuge ou par pulvérisation à ultrasons. La deuxième phase est destinée à illuminer sélectivement une partie de la résine photosensible. On comprend donc que suivant la nature de la résine photosensible, c'est-à-dire si la résine est du type positive ou négative, l'illumination sera focalisée sur les futures cavités 8 souhaitées ou sur les parties autres que les futures cavités 8 souhaitées.

Enfin, l'étape 5 se termine avec une troisième phase destinée à développer la résine photosensible 6 sélectivement illuminée afin de structurer le moule, c'est-à-dire durcir la résine photosensible 6 restant entre les cavités 8. Cette troisième phase est généralement obtenue par une attaque chimique destinée à former les cavités 8 suivie d'un traitement thermique destinée à durcir la résine encore présente.

Le procédé 1 se poursuit, comme illustré à la figure 3, avec une troisième étape 7 destinée à remplir les cavités 8 du moule par galvanoplastie pour former une pièce métallique 21, 51, 81. Comme expliqué ci-dessus, la pièce métallique 21, 51, 81 possède un même motif en projection. On comprend donc que le procédé LIGA ne comporte pas de difficultés additionnelles pour sa mise mettre en oeuvre comme, par exemple, d'autres motifs sur des niveaux supérieurs.

Avantageusement selon l'invention, le procédé 1 permet, grâce à l'étape 5 très précise de photolithographie, d'obtenir une pièce métallique 21, 51, 81 avec des cotes externes et, éventuellement, internes d'une grande précision propre à respecter les tolérances très élevées d'une pièce de micromécanique dans le domaine de l'horlogerie. Par cotes internes, il faut comprendre, qu'à partir d'éventuelles parties de résine 6 structurée qui sont enclavée dans des cavités 8, des ajourages et/ou des trous dans la pièce métallique 21, 51, 81 peuvent être directement formés lors de l'étape 7.

Dans le but de mettre en oeuvre le procédé pour fabriquer des pièces de micromécanique 31, 41, 61, 91 pour l'horlogerie, il est préféré d'utiliser un matériau qui est tribologiquement avantageux pour des contacts avec des pièces en rubis, en acier ou en laiton. De plus, une faible sensibilité aux champs magnétiques est recherchée. Enfin, en vue de faciliter l'étape 9, il est également préférable que le matériau ne soit pas trop dur. Ainsi, au vu des contraintes ci-dessus, il est apparu particulièrement adapté de remplir les cavités 8 lors de l'étape 7 avec un alliage formé de nickel et de phosphore (NiP) et notamment un tel alliage dont la proportion de phosphore est sensiblement égale à 12% (NiP12).

Le procédé 1 se poursuit, comme illustré à la figure 4, avec une étape 9 destinée à usiner sélectivement une partie de la pièce métallique 21, 51, 81 afin de former une pièce de micromécanique 31, 41, 61, 91 à au moins deux niveaux distincts. Comme expliqué ci-dessus, la pièce métallique 21, 51, 81 possédant un même motif en projection est alors modifiée dans son épaisseur afin de former au moins deux motifs sur plusieurs niveaux. On obtient ainsi la pièce de micromécanique 31, 41, 61, 91 souhaitée sans avoir à former plusieurs niveaux empilés à partir de procédés LIGA successifs.

On comprend toute l'importance de la forte adhérence de chaque pièce métallique 21, 51, 81 contre la surface supérieure 4 du substrat 2. En effet, lors de l'usinage de l'étape 9, chaque pièce métallique 21, 51, 81 sera soumise à de fortes contraintes. Dès lors, si l'adhérence n'est pas suffisante, le procédé 1 perd le bénéfice du positionnement précis de chaque pièce métallique 21, 51, 81 sur le substrat 2, voire risque de cisailler les pièces métalliques 21, 51, 81 au point de les désolidariser du substrat 2.

Au contraire, avec cette forte adhérence, du fait du positionnement précis de chaque pièce métallique 21, 51, 81 sur le substrat 2, il est possible, lors de l'étape 9, d'usiner chaque pièce métallique 21, 51, 81 encore sur le substrat 2 avec un automate programmable selon des cotes précises. On remarque que, même si l'étape 9 est destinée à usiner chaque pièce métallique 21, 51, 81, une partie de la résine 6 structurée peut toutefois également être usinée par les contraintes induites par les outils utilisés ou les volumes à enlever comme illustré par les dégagements visibles à la figure 4.

Enfin, Le procédé 1 se termine, comme illustré à la figure 5, avec l'étape 11 destinée à libérer la pièce de micromécanique 31, 41, 61, 91 du substrat 2 et de la résine photosensible 6. Ainsi, selon une première phase 12, l'étape 11 est destinée à retirer la résine photosensible 6 puis dans une deuxième phase 14, destinée à retirer le substrat 2. La phase 12 peut être obtenue, par exemple, par une attaque plasma alors que la phase 14 est, préférentiellement, obtenue par une attaque chimique. De manière préférée, dans le cas où une couche électriquement conductrice serait utilisée pour former la surface supérieure 4 électriquement conductrice, cette dernière serait, également lors de la phase 14, retirée et, éventuellement, récupérée à l'aide d'une attaque chimique sélective.

Bien entendu, la présente invention ne se limite pas à l'exemple illustré mais est susceptible de diverses variantes et modifications qui apparaîtront à l'homme de l'art. En particulier, le procédé 1 peut comporter une étape optionnelle 10, entre l'étape 7 et l'étape 9, destinée à mettre à niveau par rodage le moule formée en résine photosensible 6 et la pièce métallique 21, 51, 81. Cette étape optionnelle peut être souhaitée pour garantir les cotes de la pièce de micromécanique 31, 41, 61, 91, c'est-à-dire être sûr que le moule est complètement rempli.

Il est également envisageable de profiter de la présence de plusieurs pièces métalliques 21, 51, 81 sur le même substrat 2 pour les revêtir d'une couche prédéterminée. Ainsi, le procédé 1 peut, comme illustré à la figure 6, comporter une phase optionnelle 16, entre la phase 12 et la phase 14, destinée à déposer un revêtement 13 sur l'ensemble pièce de micromécanique pièce de micromécanique 31, 41, 61, 91 - substrat 2. Une telle phase 16 peut être obtenue, par exemple, par un dépôt physique ou chimique en phase vapeur, une galvanoplastie ou tout autre type de dépôt.

A l'issue de la phase 14, on obtient alors une pièce de micromécanique 31, 41, 61, 91 partiellement revêtue d'une couche 13. Préférentiellement, la couche 13 est destinée à améliorer la tribologie de la pièce de micromécanique 31, 41, 61, 91 comme, par exemple, formée à partir d'un allotrope du carbone tel que du graphène ou du carbone sous forme diamant. Toutefois, la couche 13 peut également être utilisée pour une autre fonction comme changer la couleur ou la dureté de la pièce de micromécanique 31, 41, 61, 91.

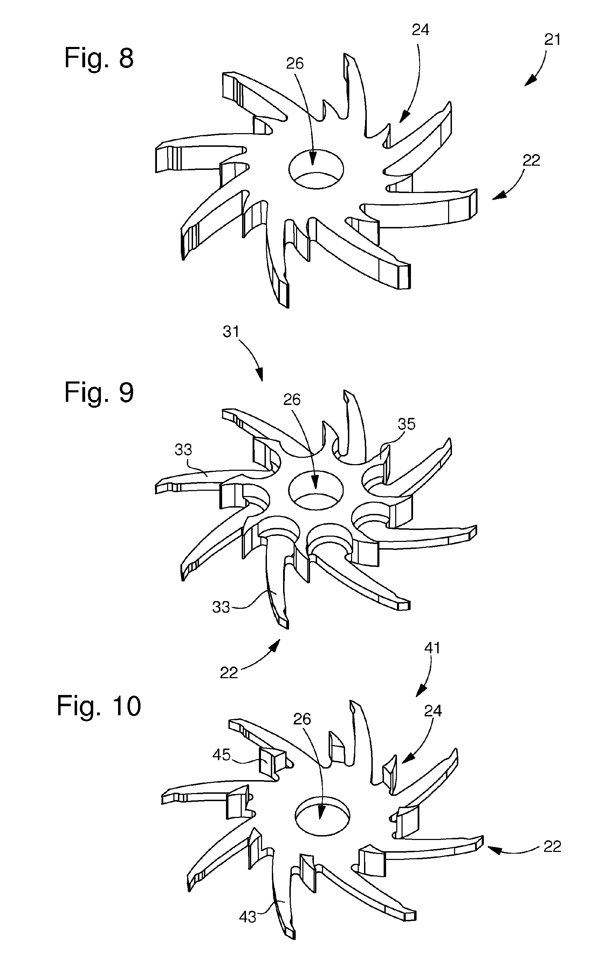

Des exemples d'applications horlogères sont présentés à l'aide de trois variantes illustrées aux figures 8 à 16. Dans une première variante illustrée aux figures 8 à 10, est présentée une pièce métallique 21 obtenue lors de l'étape 7 du procédé 1. Elle se présente généralement sous la forme d'une étoile à double dentures 22, 24 comportant un trou central 26. A l'issue de l'étape 11 du procédé 1, on peut ainsi obtenir une pièce de micromécanique prenant la forme d'une roue d'échappement 31 illustrée à la figure 9 ou d'une roue d'échappement 41 illustrée à la figure 10, l'un et l'autre étant monobloc et comportant au moins deux niveaux distincts revêtues ou non d'une couche 13.

Ainsi, dans le cas de la figure 9, la pièce métallique 21 a été usinée au niveau des huit bras 33 dont chaque extrémité forme la denture 22 dans un niveau inférieur. Le reste de la pièce métallique 21 est restée inchangée notamment au niveau du trou 26 et des huit bras 35 dont chaque extrémité forme la deuxième denture 22 dans le niveau inférieur et dans un niveau supérieur.

De manière alternative, dans le cas de la figure 10, la pièce métallique 21 a été usinée au niveau des huit bras 43 dont chaque extrémité forme la denture 22 dans un niveau inférieur. De manière similaire, l'entourage du trou 26 a été usiné afin de laisser présent le trou 26 que dans le niveau inférieur. Enfin, les huit bras 45 et une partie du niveau supérieur ont été usiné afin qu'il ne subsiste que les extrémités des bras 45 en gardant la deuxième denture 22 dans le niveau inférieur et dans le niveau supérieur.

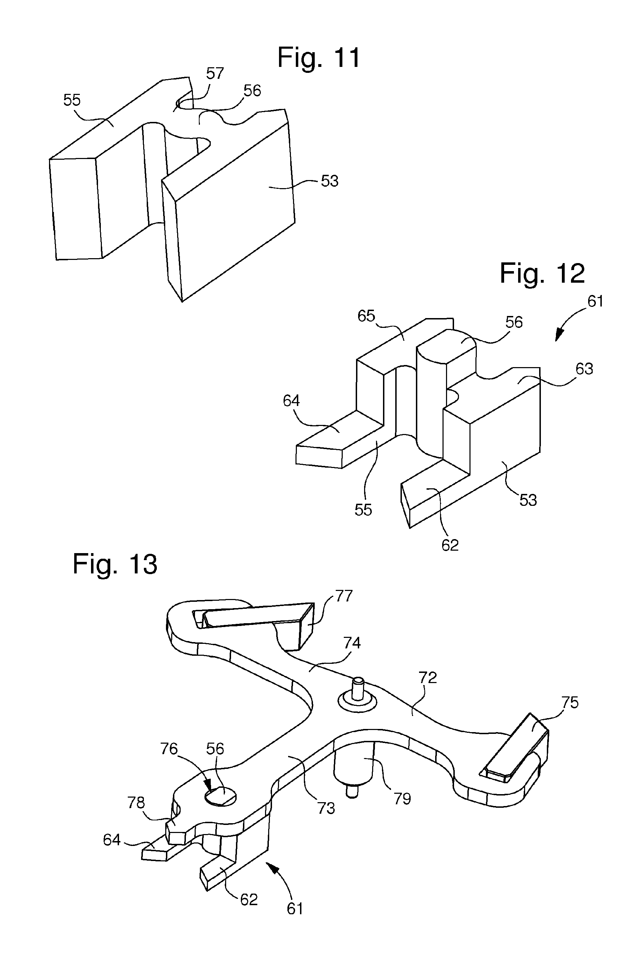

Dans une deuxième variante illustrée aux figures 11 à 13, est présentée une pièce métallique 51 obtenue lors de l'étape 7 du procédé 1. Elle se présente généralement sous la forme d'une pièce en H comportant deux parties 53, 55 parallèles reliées entre elle par une portion transversale 57. Comme visible à la figure 11, la portion transversale 57 comporte une partie centrale 56 dont la section est plus évasée que le reste de la portion.

A l'issue de l'étape 11 du procédé 1, on peut ainsi obtenir une pièce de micromécanique prenant la forme d'une fourchette 61 illustrée à la figure 12 monobloc et comportant au moins deux niveaux distincts revêtue ou non d'une couche 13. Ainsi, la pièce métallique 51 a été usinée au niveau des deux parties 53, 55 parallèles selon deux profondeurs, c'est-à-dire en formant trois niveaux, et au niveau de la partie non évasée de la portion transversale 57 selon une seule profondeur.

Dans l'exemple de la figure 12, la fourchette 61 comporte ainsi la totalité des parties 53, 55 parallèles uniquement au niveau inférieur en formant deux cornes 62, 64. Un niveau intermédiaire comporte seulement partiellement les parties 53, 55 parallèles et la partie non évasée de la portion transversale 57 en formant des épaulements 63 et 65. Enfin seule la partie centrale 56 de la portion transversale 57 est conservée de la pièce métallique 51 en formant uniquement dans le niveau supérieur un tenon.

Comme visible à la figure 13, la fourchette 61 peut ensuite être montée, par chassage de la partie centrale 56 formant tenon, dans le trou 76 d'une baguette 73 pour former une ancre 71. La baguette 73 peut elle-même être obtenue par un procédé LIGA avec un dard 78 en une pièce. En plus, de la fourchette 61, la baguette 73 peut être équipée de palettes 75, 77 au niveau de ses bras 72, 74 et d'un axe de pivotement 79. Bien entendu, avantageusement selon l'invention, tout ou partie de l'ancre 71 peut également être obtenue à l'aide du procédé 1 selon l'invention. A titre d'exemple, les palettes 75, 77, la baguette 73, le dard 78, le trou 76 pourraient être monoblocs et obtenus à partir du procédé 1 selon l'invention.

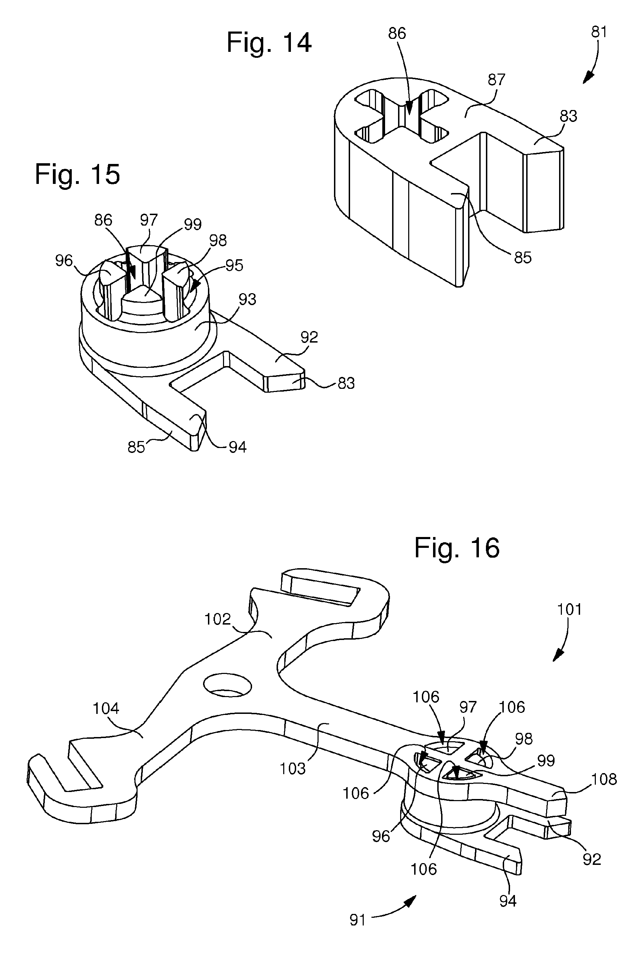

Dans une troisième variante illustrée aux figures 14 à 16, est présentée une pièce métallique 81 obtenue lors de l'étape 7 du procédé 1. Elle se présente généralement sous la forme d'une pièce en U comportant deux parties 83, 85 parallèles reliées entre elle par une base 87. Comme visible à la figure 14, la base est plus épaisse que la partie 83, 85 parallèles pour permettre la formation d'un ajourage 86 sensiblement en forme de croix.

A l'issue de l'étape 11 du procédé 1, on peut ainsi obtenir une pièce de micromécanique prenant la forme d'une fourchette 91 illustrée à la figure 15 monobloc et comportant au moins deux niveaux distincts revêtue ou non d'une couche 13. Ainsi, la pièce métallique 81 a été usinée au niveau des deux parties 83, 85 parallèles selon une seule profondeur et au niveau de la base 87 selon deux profondeurs, c'est-à-dire en formant trois niveaux,

Dans l'exemple de la figure 15, la fourchette 61 comporte ainsi la totalité des parties 83, 85 parallèles uniquement au niveau inférieur en formant deux cornes 92, 94. Un niveau intermédiaire comporte seulement partiellement la base 87 en formant un cylindre 93 se rétrécissant par un épaulement 95 pour former le niveau supérieur. Enfin, le rétrécissement est utilisé pour faire libérer l'ajourage 86 dans le niveau supérieur et former quatre tenons 96, 97, 98, 99.

Comme visible à la figure 15, la fourchette 91 peut ensuite être montée, par chassage des tenons 96, 97, 98, 99, dans les trous 106 d'une baguette 103 pour former une ancre 101. La baguette 103 peut elle-même être obtenue par un procédé LIGA avec un dard 108 en une pièce. En plus, de la fourchette 91, la baguette 103 peut être équipée, de manière similaire à la deuxième variante, de palettes au niveau de ses bras 102, 104 et d'un axe de pivotement. Bien entendu, avantageusement selon l'invention, tout ou partie de l'ancre 101 peut également être obtenue à l'aide du procédé 1 selon l'invention. A titre d'exemple, les palettes, la baguette 103, le dard 108, les trous 106 pourraient être monoblocs et obtenus à partir du procédé 1 selon l'invention.

Par conséquent, avantageusement selon l'invention, les cotes externes 22, 24, 53, 55, 56, 83, 85 et, éventuellement, internes 26, 86 restent à la grande précision induit par le procédé LIGA et le reste de la pièce de micromécanique 31, 41, 61, 91 monobloc bénéficie de la précision de l'usinage afin de préserver les couts de fabrication. On obtient donc une pièce de micromécanique 31, 41, 61, 91 monobloc comportant au moins deux niveaux distincts qui est beaucoup moins difficile à fabriquer en gardant les parties externes 22, 24, 53, 55, 56, 83, 85 et, éventuellement, internes 26, 86 d'une très grande précision.

Bien entendu, la présente invention ne se limite pas à l'exemple illustré mais est susceptible de diverses variantes et modifications qui apparaîtront à l'homme de l'art. En particulier, dans le domaine de l'horlogerie, les pièces de micromécanique 31, 41, 61, 91 ne sauraient se limiter à un tout ou partie d'un mobile ou d'une ancre. D'autres pièces horlogères peuvent être envisagées comme, notamment, des ponts, des platines ou des balanciers.

De plus, comme expliqué ci-dessus, il est également envisageable d'appliquer la présente invention dans d'autres domaines que l'horlogerie comme, notamment, l'aéronautique ou l'automobile.

## Revendications

1. Procédé (1) de fabrication d'une pièce de micromécanique (31, 41, 61, 91) monobloc comportant au moins deux niveaux distincts **caractérisé en ce qu'il** comporte les étapes suivantes :
a) former (3) un substrat (2) en silicium dont la surface supérieure (4) est électriquement conductrice ;
b) structurer (5) un moule à partir d'une résine photosensible (6) afin de fabriquer des cavités (8) dont le fond est formé par ladite face supérieure (4) électriquement conductrice ;
c) remplir (7) les cavités (8) du moule par galvanoplastie pour former une pièce métallique (21, 51, 81) ;
d) usiner (9) sélectivement une partie de la pièce métallique (21, 51, 81) afin de former une pièce de micromécanique (31, 41, 61, 91) monobloc à au moins deux niveaux distincts ;
e) libérer (11) la pièce de micromécanique (31, 41, 61, 91) du substrat (2) et de la résine photosensible (6).

2. Procédé (1) selon la revendication précédente, **caractérisé en ce que** la surface supérieure (4) est rendue électriquement conductrice par le dopage du substrat (2) en silicium et/ou par le dépôt d'une couche électriquement conductrice sur le substrat (2) en silicium.

3. Procédé (1) selon la revendication 1 ou 2, **caractérisé en ce que** le substrat (2) en silicium comporte une épaisseur comprise entre 0,3 et 1 mm.

4. Procédé (1) selon l'une des revendications précédentes, **caractérisé en ce que** l'étape b) comporte les phases suivantes :
f) déposer une couche de résine photosensible (6) sur la surface supérieure (4) électriquement conductrice du substrat (2) ;
g) illuminer sélectivement une partie de la résine photosensible (6) ;
h) développer la résine photosensible (6) afin de structurer le moule.

5. Procédé (1) selon l'une des revendications précédentes, **caractérisé en ce que** la pièce métallique (21, 51, 81) est formée à base de nickel-phosphore (NiP, NiP12).

6. Procédé (1) selon l'une des revendications précédentes, **caractérisé en ce qu'il** comporte en outre entre l'étape c) et l'étape d), l'étape suivante :
i) mettre (10) à niveau, par rodage, le moule et la pièce métallique (21, 51, 81).

7. Procédé (1) selon l'une des revendications précédentes, **caractérisé en ce que**, lors de l'étape e), le procédé (1) comporte les phases suivantes :
j) retirer (12) la résine photosensible ;
k) retirer (14) le substrat ;
et, **en ce qu'**entre la phase j) et la phase k), le procédé (1) comporte en outre la phase suivante :
l) déposer (16) un revêtement (13) sur l'ensemble pièce de micromécanique (31, 41, 61, 91) - substrat (2).

8. Procédé (1) selon la revendication précédente, **caractérisé en ce que** la phase l) est réalisée par dépôt physique ou chimique en phase vapeur.

9. Procédé (1) selon la revendication 7, **caractérisé en ce que** la phase l) est réalisée par galvanoplastie.

10. Procédé (1) selon l'une des revendications précédentes, **caractérisé en ce que** plusieurs pièces de micromécanique (31, 41, 61, 91) sont formées sur le même substrat (2).

11. Pièce d'horlogerie **caractérisée en ce qu'**elle comporte une pièce de micromécanique (31, 41, 61, 73, 91, 103) monobloc à au moins deux niveaux distincts obtenue selon l'une des revendications précédentes.
